# EUROPÄISCHE PATENTSCHRIFT

(11) **EP 1 654 754 B1**
(45) Veröffentlichungstag und Bekanntmachung des Hinweises auf die Patenterteilung: **21.02.2007**
(21) Anmeldenummer: 04766355.4
(22) Anmeldetag: 28.07.2004
(51) Int. Cl.: H01L 21/205, C23C 16/455, C30B 25/14, C30B 25/02, F17C 13/04, B01F 3/02

(54) **GASVERSORGUNGSANORDNUNG, INSBESONDERE FÜR EINEN CVD-PROZESSREAKTOR ZUM AUFWACHSEN EINER EPITAXIESCHICHT**
GAS-SUPPLY ASSEMBLY, IN PARTICULAR FOR A CVD PROCESS REACTOR FOR GROWING AN EPITAXIAL LAYER
DISPOSITIF D'ALIMENTATION, EN PARTICULIER POUR UN REACTEUR DE DEPOT CHIMIQUE EN PHASE VAPEUR UTILISE POUR LA CROISSANCE D'UNE COUCHE EPITAXIALE

(30) Priorität: 14.08.2003 DE 10337568
(43) Veröffentlichungstag der Anmeldung: 10.05.2006
(73) Patentinhaber: Infineon Technologies AG, 81669 München (DE)
(72) Erfinder: BAUMGARTL, Johannes, A-9587 Riegersdorf (AT); KOGLER, Rudolf, A-9220 Velden (AT); VALLANT, Thomas, A-9500 Villach (AT)
(74) Vertreter: Kindermann, Peter
(86) Internationale Anmeldenummer: PCT/EP2004/051646
(87) Internationale Veröffentlichungsnummer: WO 2005/017985

(56) Entgegenhaltungen:
- WO-A-03/016590
- DE-A- 19 510 853
- US-B1- 6 187 091
- US-B1- 6 296 026

## Beschreibung

Die Erfindung betrifft eine Gasversorgungsanordnung für einen Prozessreaktor, insbesondere für einen CVD-Prozessreaktor (Chemical Vapor Deposition) zum Aufwachsen einer Epitaxieschicht. Die Epitaxieschicht ist bspw. eine monokristalline Siliziumschicht, die in-situ dotiert wird.

Die Epitaxie-Abscheidung ist ein wesentlicher Schritt bei der Herstellung von Halbleiterbauteilen. Die Epitaxieschicht wird bspw. mittels gasförmigem Precursor, z.B. Trichlorsilan SiHCl₃, Dotierstoff, z.B. Phosphin PH₃ oder Arsin AsH₃, und Wasserstoff H₂ erzeugt.

Ein geeigneter Prozessreaktor mit zugehörigem Gasversorgungssystem ist bspw. aus der US Patentschrift 6 187 091 bekannt. Um Hilfsgase zum Reinigen oder Spülen des Reaktors einspeisen zu können, könnte man zwischen der Mischstelle zum Mischen der Prozessgase und der der Mischstelle benachbarten Verzeigung eine Umschalteinheit anordnen, die bspw. ein Umschaltventil oder mehrere Umschaltventile enthält.

Eine Umschalteinheit enthält bspw. einen Hauptanschluss und mindestens zwei Nebenanschlüsse, wobei wahlweise ein Gasdurchlasskanal zwischen dem Hauptanschluss und dem einen Nebenanschluss oder zwischen dem Hauptanschluss und dem anderen Nebenanschluss geöffnet ist.

Ein Ende der Prozessgasleitung wäre an dem einen Nebenanschluss anzuordnen. Ein Ende einer Hilfsleitung zum Einleiten der Hilfsgase wäre an dem anderen Nebenanschluss anzuordnen. Ein Ende der Reaktorleitung wäre an dem Hauptanschluss und das andere Ende der Reaktorleitung wäre an Gaseinlassanschluss des Prozessreaktors anzuordnen.

Die WO 03/016590 A3 zeigt eine Vorrichtung zur Zufuhr von Gasgemischen zu einem CVD-Reaktor. Ein Gasgemisch wird durch Zerstäuben einer Flüssigkeit an einem Einspritzventil erzeugt. Stickstoff kann alternativ zum Reaktor geführt werden, so dass auch eine Gasquellen-Umschalteinheit vorhanden ist.

Es ist Aufgabe der Erfindung eine verbesserte Gasversorgungsanordnung anzugeben, die insbesondere die Herstellung der Epitaxieschicht in hoher Qualität erlaubt.

Diese Aufgabe wird durch eine Gasversorgungsanordnung mit den Merkmalen des Patentanspruchs 1 gelöst. Weiterbildungen sind in den Unteransprüchen angegeben.

Die Erfindung geht von der Überlegung aus, dass sich während der Prozessierung ändernde Prozessparameter zu einem ungleichmäßigen Schichtwachstum führen, insbesondere hinsichtlich der Schichtdicke und der Dotierstoffverteilung. Viele dieser Änderungen werden vom Gasversorgungssystem hervorgerufen oder begünstigt, insbesondere Druck-, Temperatur- und Gasflussschwankungen.

Deshalb wird erfindungsgemäß die Reaktorleitung kürzer als ein Meter oder kürzer als fünfzig Zentimeter oder kürzer als fünfundzwanzig Zentimeter ausgebildet. Bei dieser Maßnahme wird die Umschalteinheit so nah wie möglich am Prozessreaktor angeordnet, so dass die Prozessgase bis unmittelbar an den Prozessreaktor heran nur in der Prozessgasleitung geleitet werden, die nur für die Prozessgase vorgesehen ist. Die Reaktorleitung ist so kurz, dass in ihr nur eine unwesentliche Vermischung bzw. Reaktion von Prozessgasen und vorher durch die Reaktorleitung transportierten Gasen auftritt. Die Folge sind gleichmäßigere Reaktionsbedingungen, insbesondere am Anfang der Epitaxie.

Bei einer Weiterbildung ist die Hilfsleitung Bestandteil eines Gasquellenzweiges mit mindestens einer Gasquelle, die Hilfsgase am anderen Ende der Hilfsleitung in die Hilfsleitung einspeist, vorzugsweise einer Wasserstoffquelle und einer Chlorwasserstoffquelle. Bei der Weiterbildung arbeitet die Umschalteinheit als Gasquellen-Umschalteinheit. In der Hilfsleitung transportierte Waferreinigungsgase bzw. Purgegase und Kammerreinigungsgase bzw. Cleangase werden von den Prozessgasen räumlich bis kurz vor die Kammer getrennt. Stark unterschiedliche Gaskonzentrationen der Prozessgase in der Reaktorleitung beim Wechsel von einem Reinigungsschritt zu einem Abscheideprogramm werden vermieden. Durch das konstante Gasverhältnis von bspw. Phospin, Trichlorsilan und Wasserstoff werden Abweichungen der Epitaxieschicht auf nacheinander bearbeiteten Wafern vermieden.

Bei einer alternativen Weiterbildung ist die Hilfsleitung Bestandteil eines Gasumleitungszweiges, durch den Prozessgase am Prozessreaktor vorbei zu dem anderen Ende der Hilfsleitung geleitet werden, insbesondere zu einem Gasauslass. Die Umschalteinheit arbeitet bei der alternativen Weiterbildung als Umleitungs-Umschalteinheit. Während des Waferreinigungsschrittes lassen sich die Prozessgase durch die alternative Weiterbildung bis unmittelbar vor die Prozesskammer in einem genau eingestellten Verhältnis transportieren. Nach dem Umschalten strömen die Prozessgase dann ohne große Verzögerung und in fast unverändertem Verhältnis in die Prozesskammer ein.

Bei einer nächsten Weiterbildung werden die beiden alternativen Weiterbildungen kombiniert, wobei die beiden Prozessgasleitungen einen gemeinsamen Leitungsabschnitt haben. Auch die beiden Reaktorleitungen haben einen gemeinsamen Leitungsabschnitt. Es wird durch die Kombination eine besonders gleichmäßige Prozessführung ermöglicht, insbesondere auch bei einem Wechsel der Prozessgaszusammensetzung im Vergleich zu einem vorhergehenden Zyklus.

Bei einer Ausgestaltung der Kombination ist entweder die Gasquellen-Umschalteinheit in der an die Umleitungs-Umschalteinheit angeschlossenen Reaktorleitung enthalten oder die Umleitungs-Umschalteinheit ist in der an die Gasquellen-Umschalteinheit angeschlossenen Reaktorleitung enthalten.

Bei einer nächsten Weiterbildung ist die Prozessgasleitung Bestandteil eines Prozessgasquellenzweiges mit mindestens einer Prozessgasquelle, die Prozessgase am anderen Ende der Prozessgasleitung in die Prozessgasleitung einspeist. Der Prozessgasquellenzweig enthält bspw. eine Wasserstoffquelle und eine Silanquelle, insb. eine Mono-, Di-, Tri- oder Tetrachlorsilanquelle, und eine Dotierstoffquelle, bspw. eine Phosphinquelle. Die Gase der verschiedenen Gasquellen werden über eine Mischeinrichtung zusammengeführt, insbesondere über eine Mischeinrichtung mit Druckregelung.

Zusammenfassend gilt, dass durch die Trennung des Prozessgasgemisches, z.B. Trichlorsilan, Dotiergas und Trägergas, vom Ätzgasgemisch, z.B. Chlorwasserstoff, keine Quervermischung der unterschiedlichen Gase in vergleichsweise langen gemeinsamen Zuleitungen auftreten. Außerdem sind kürzere Spülzeiten und eine bessere Prozesskontrolle von Wafer zu Wafer möglich. Das Spülen der Prozessgase bis unmittelbar vor die Prozesskammer führt zu minimalen Totvolumina und definierten Prozessgaskonzentrationen auch unmittelbar nach Beginn des Beschichtungsschrittes im Prozess.

Gemäß einer Weiterbildung oder gemäß einem zweiten Aspekt der Erfindung, der unabhängig von dem bereits erläuterten Aspekt ist, enthält der Prozessgaszweig:
- eine erste Gasleitung, die Bestandteil eines ersten Gasquellenzweiges ist, eine zweite Gasleitung, die Bestandteil eines zweiten Gasquellenzweiges ist,
- eine Gaszusammenführeinheit, die einen Hauptanschluss und mindestens zwei Nebenanschlüsse enthält, wobei das eine Ende der ersten Gasleitung an den einen Nebenanschluss und das eine Ende der zweiten Gasleitung an dem anderen Nebenanschluss angeordnet ist,
- eine zwischen dem Hauptanschluss und mindestens einer Durchflussbeeinflussungseinheit angeordneten Verbundeinheit, die einen Gaskanal bildet, und
- eine von der Verbundeinheit abzweigende Druckbeeinflussungseinheit, die den sich in der Verbundeinheit einstellenden Druck beeinflusst.

Die Druckbeeinflussungseinheit ist eine Druckregeleinheit mit Druckerfassungseinheit, automatisch betätigtem Ventil sowie einer eingangsseitig an der Druckerfassungseinheit und ausgangsseitig an dem Ventil angeordneten Regeleinheit. Die Druckbeeinflussungseinheit erfasst den Ist-Druck, ermittelt die Abweichung des Ist-Druckes von einem vorgegebenen Soll-druck, und betätigt das Ventil abhängig von der Abweichung so, dass der Ist-Druck dem Soll-Druck angeglichen wird. Der Gasdruck der Gasmischanlage wird so stabil gehalten. Im Zusammenspiel mit der der Gasmischanlage nachgeschalteten Durchflussbeeinflussungseinrichtung, z.B. einem Massedurchflussregeleinrichtung erfährt der gemischte Gasfluss eine zusätzliche Stabilisierung, da die Massedurchflussregeleinrichtung einen konstanten Druck an ihrem Eingang voraussetzt. Der Ist-Wert des Drucks wird bei einer Ausgestaltung vorzugsweise innerhalb eines Druckfensters überwacht und führt beim Überschreiten eines oberen Grenzwertes oder beim Unterschreiten eines unteren Grenzwertes zu einer Warnmeldung, welche einen Regelungsvorgang einleitet oder die bspw. auf einer Anzeigeeinheit oder durch ein akustisches Signal ausgegeben wird. Der Druckregelungsvorgang kann auch proportional zur Differenz von Soll- und Ist-Wert ausgeführt werden.

In der Gasmischeinheit werden insbesondere Wasserstoff und ein bereits mit Wasserstoff vorverdünnter Dotierstoff, z.B. vorverdünntes Phosphin, gemischt.

Zusammenfassend gilt, dass durch die elektronische Drucküberwachung und Regelung in der Dotiergasmischeinheit eine stabilere Dotierstoffkonzentration erzeugt werden kann.

Gemäß einer anderen Weiterbildung enthält die Gasversorgungsanordnung einen Rahmen zum Befestigen der folgenden Einheiten:
- des Prozessreaktors und mindestens eines weiteren Prozessreaktors, wobei die Prozessreaktoren jeweils eine eigene Prozesskammer enthalten, die von anderen Prozesskammern getrennt ist,
- eine erste Gasmischeinrichtung, die ein Verdünnungsgas und ein Dotiergas mischt,
- eine zwischen der ersten Gasmischeinrichtung und dem ersten Gasreaktor angeordneten Gasversorgungszweig,
- mindestens eine weitere Gasmischeinrichtung, die den gleichen Aufbau wie die erste Gasmischeinrichtung hat, und
- einen weiteren Gasversorgungszweig, der von der weiteren Gasmischeinrichtung zu dem weiteren Prozessreaktor führt.

Alle Gasversorgungszweige führen voneinander getrennt Prozessgase zum jeweiligen Prozessreaktor.
Der Rahmen trägt eine vollständige Anlage, die bspw. eine eigene Stromversorgung und eine eigene Wasserversorgung für einen Kühlkreislauf enthält. Die Prozesskammern einer Anlage werden von einem zentralen Beladeroboter der Anlage beladen.

Jede Prozesskammer wird demzufolge von einer eigenen Gasmischeinrichtung versorgt, so dass gegenseitige Beeinflussungen der Prozesse in verschiedenen Kammern vermieden werden.
Insbesondere gibt es keine Rückwirkung auf andere Kammern, wenn eine Kammer beladen oder entladen wird. Die Dotierstoffkonzentration kann so sehr genau eingestellt werden. Andere Ursachen für Fehler in Dotiergasflüssen, die durch Druck- und Flussschwankungen hervorgerufen werden, sind nichtsynchrone Zugriffe auf gemeinsam genutzte Gasleitungen. Diese Ursachen werden ebenfalls beseitigt.

Außerdem können in verschiedenen Prozesskammern einer Anlage Epitaxieschichten mit verschiedenen Dotierungen gleichzeitig erzeugt werden, z.B. von Dotierstoffkonzentrationen, die sich um mehr als eine Zehnerpotenz unterscheiden.

Bei einer Weiterbildung wird zur Vermeidung von Rückströmungen der Gase in eine Auslassleitung ein Ballastgas eingeleitet, z.B. molekularer Stickstoff. Die Stabilität der Gasflüsse erhöht sich dadurch weiter. Bspw. beträgt der Durchfluss des Ballastgases 20 bis 30 sccm (Standardkubikzentimeter pro Minute).

Bei einer Weiterbildung ist an die erste Gasmischeinrichtung und an die zweite Gasmischeinrichtung eine gemeinsame oder jeweils eine getrennte Dotiergasquelle angeschlossen, die Dotiergas mit einer Dotierstoffkonzentration bspw. größer als 0,1 ppm (parts per million) oder größer als 1 ppm liefert. Bei einer Ausgestaltung enthält die Gasversorgungsanordnung mindestes zwei weitere Mischeinrichtungen, in denen die Dotierstoffkonzentration weiter verringert wird, z.B. in einem Verhältnis kleiner als 1:100 oder kleiner als 1:1000. Die weiteren Mischeinrichtungen sind jeweils der ersten Gasmischeinrichtung bzw. der zweiten Gasmischeinrichtung nachgeschaltet.

Bei einer Weiterbildung sind die erste Gasmischeinrichtung und die zweite Gasmischeinrichtung jeweils Gasmischeinrichtungen nach dem zweiten Aspekt, so dass die Stabilität der Dotierstoffkonzentration auf zwei Wegen und damit in einem bisher nicht angetroffenen Maße erhöht wird.

Zusammenfassend gilt, dass durch die für jede Prozesskammer getrennte Gasmischung unterschiedliche Dotierungen für jede einzelne Kammer möglich sind. außerdem lassen sich Druckschwankungen erheblich reduzieren.

Gemäß einer anderen Weiterbildung enthält die Gasversorgungsanordnung:
- mehrere Gasversorgungsleitungen, an denen jeweils mindestens eine Gasquelle angeschlossen ist,
- mindestens einen Prozessreaktor,
- ein Gasleitungssystem zwischen den Gasversorgungsleitungen und dem Prozessreaktor,
- eine an das Gasleitungssystem angeschlossene Unterdruckpumpe, die im Vergleich zum Umgebungsdruck einen Unterdruck erzeugt, und
- in jeder Gasleitung ein Absperrventil.

Eine Überprüfung auf ein Leck im Gasversorgungssystem lässt sich auf einfache Weise durchführen, durch:
- Evakuieren des Gasleitungssystems mit der Unterdruckpumpe,
- Abschalten der Unterdruckpumpe,
- Überprüfen des Drucks im Gasleitungssystem nach einer vorgegebenen Testzeit, z.B. nach 5 Minuten.
Ein Druckanstieg zeigt an, dass ein Leck vorhanden ist.

Bei einer Weiterbildung ist die Unterdruckpumpe über eine Leitung angeschlossen, die von einer Umleitungs-Leitung abzweigt, die Prozessgase am Prozessreaktor vorbeileitet. Dadurch ist gewährleistet, dass das Gasleitungssystem vollständig oder doch zu mehr als 50 Prozent mit einer Unterdruckpumpe evakuiert werden kann.

Bei einer nächsten Weiterbildung ist eine Gasquelle vorhanden, die an Stelle der Unterdruckpumpe zuschaltbar ist, insbesondere eine Heliumgasquelle. Damit kann ein Leck leicht geortet werden, indem nach dem Evakuieren des Gasleitungssystems mit der Unterdruckpumpe, das Gas zum Belüften des Gasleitungssystems eingeleitet wird. Das Ausströmen des Gases aus einem Leck ist gut messbar, bspw. mit einem Leckdetektor.

Zusammenfassend gilt, dass sich mit der Gasversorgungsanordnung ein einfacher Lecktest ausführen lässt.

Gemäß einer anderen Weiterbildung enthält die Gasversorgungsanordnung:
- mehrere Gasversorgungsleitungen, an denen jeweils mindestens eine Gasquelle angeschlossen ist,
- mindestens einen Prozessreaktor,
- ein Gasleitungssystem zwischen den Gasversorgungsleitungen und dem Prozessreaktor,
- eine Umleitungs-Leitung, die Prozessgase und/oder Reinigungsgase am Prozessreaktor vorbeileitet, und
- eine in der Umleitungs-Leitung angeordnete Durchflusserfassungseinheit.

Die Durchflusserfassungseinheit ist bspw. ein Massedurchflussregler bzw. ein Mass Flow Controller. Durch die Weiterbildung lassen sich die in dem Gasleitungssystem enthaltenen Durchflusserfassungseinheiten auf einfache Art und Weise prüfen, insbesondere ohne aufwändigen Ausbau und ohne dass an schwer zugänglichen Stellen der Anlage gearbeitet werden muss. Die in der Umleitungs-Leitung enthaltene Durchflusserfassungseinheit dient als Referenzeinheit, mit der alle Durchflusserfassungseinheiten oder doch mehr als fünfzig Prozent der Durchflusserfassungseinheiten der Anlage geprüft werden können.

Beim Prüfen wird wie folgt vorgegangen:
- Auswahl einer zu prüfenden Durchflusserfassungseinheit in der Anlage.
- Schalten eines unverzweigten Gaskanals von der ausgewählten Durchflusserfassungseinheit zu der Umleitungs-Leitung,
- Durchströmen des Gaskanals mit einem Gas,
- Erfassen des Gasstroms an der ausgewählten Durchflusserfassungseinheit und an der Referenz-Durchflusserfassungseinheit.

Werden gleiche Gasflüsse erfasst, so arbeitet die ausgewählte bzw. die zu prüfende Durchflusserfassungseinheit fehlerfrei. Werden unterschiedliche Gasflüsse erfasst, so ist die zu prüfenden Durchflusserfassungseinheit defekt und muss ausgewechselt werden. Das Auswechseln erfolgt gezielt, so dass der Montageaufwand minimal ist.

Alternativ lässt sich auch die gesamte Prozessgasmenge über die Referenz-Durchflusserfassungseinheit erfassen und mit einem APC-Programm (Advanced Process Control) kontrollieren.

Gemäß einer anderen Weiterbildung enthält die Gasversorgungsanordnung:
- einen Prozessreaktor, der eine Prozesskammer, mindestens zwei äußere Gaseinlässe und einen zwischen den äußeren Gaseinlässen angeordneten inneren Gaseinlass enthält,
- eine erste äußere Reaktorleitung, die zwischen dem einen äußeren Gaseinlass und einer Gasquelle angeordnet ist,
- eine zweite äußeren Reaktorleitung, die zwischen dem anderen äußeren Gaseinlass und der Gasquelle oder einer weiteren Gasquelle angeordnet ist, und
- eine Durchflussbeeinflussungseinheit in einem Abschnitt der ersten äußeren Reaktorleitung,
wobei der Abschnitt der ersten äußeren Reaktorleitung kein Abschnitt der zweiten äußeren Reaktorleitung ist und wobei der Abschnitt der ersten äußeren Reaktorleitung an den Prozessreaktor angrenzt.

Die Prozesskammer ist insbesondere eine Einzelwaferprozesskammer, in der jeweils nur ein einziger Wafer prozessiert wird. bspw. enthält die Prozesskammer eine Auflagevorrichtung zur Aufnahme eines einzigen Wafers. Durch die Aufnahme nur eines Wafers lässt sich eine sehr homogene Schicht erzeugen. Die Homogenität wird weiter erhöht, wenn der jeweilige Durchfluss durch eine Reaktorleitung unabhängig vom Durchfluss in einer anderen Reaktorleitung vorgegeben wird, insbesondere zusätzlich zu einer separaten Vorgabe des Durchflusses durch eine weiter innen liegende Reaktorleitung, die zu inneren Gaseinlässen führt. Alle Gaseinlässe sind insbesondere in einer Ebene aufgereiht, die parallel zur Auflagefläche für den Wafer liegt.

Eine voneinander unabhängige Regelung der Gasflüsse ermöglicht eine bessere Optimierung der Schichtgleichförmigkeit als mit bisher verwendeten Systemen. Es lässt sich eine Recipe-feine Einstellung vornehmen. Auch Reinigungsschritte lassen sich gleichmäßiger durchführen, so dass kürzere Reinigungszeiten möglich sind, bei denen die Kammerwand weniger angegriffen wird.

Bei einer Weiterbildung wird vor einer Verzweigung auf mehrere bspw. drei Reaktorleitungen eine Durchflussbeeinflussungseinheit angeordnet. In einer Reaktorleitung wird keine Durchflussbeeinflussungseinheit eingesetzt, weil nur so auf einfache Art eine beliebige Vorgabe von Durchflussmengen möglich ist. In allen anderen von der Verzweigung kommenden Reaktorleitungen sind Druckbeeinflussungseinheiten enthalten. Die Reaktorleitung ohne Durchflussbeeinflussungseinheit ist eine äußere Reaktorleitung oder eine innere Reaktorleitung

Bei einer Weiterbildung ist die Gasquelle eine Hilfsgasquelle für Nebenprozesse. Alternativ ist die Gasquelle eine Prozessgasquelle für einen Hauptprozess, insbesondere für den Epitaxieprozess.

Bei einer nächsten Weiterbildung enthält die Anlage mindestens zwei Reaktorleitungsgruppen, nämlich eine Gruppe für Hilfsgase und eine weitere Gruppe für die Prozessgase. Ein Vermischen der Hilfsgase und der Prozessgase wird dadurch auf einen kurzen gemeinsamen Abschnitt reduziert. In jeder Reaktorleitungsgruppe wird das Verhältnis der Gasflüsse in den Reaktorleitungen der Gruppe optimal eingestellt.

Gemäß einer anderen Weiterbildung enthält die Gasversorgungsanordnung:
- eine automatische Endpunkterfassungseinrichtung, die den Endpunkt einer Reinigung des Prozessreaktors erfasst, vorzugsweise ein Massespektrometer.

Durch die automatische Endpunkterkennung wird einerseits gewährleistet, dass die Prozesskammer ausreichend gereinigt ist. Andererseits wird die Wand der Prozesskammer nur in einem geringen Maße angeätzt. Insbesondere in Kombination mit der verbesserten Durchflusssteuerung in den drei Reaktorleitungen sind diese Wirkungen besonders stark ausgeprägt.

Gemäß einer anderen Weiterbildung enthält die Gasversorgungsanordnung:
- einen Prozessreaktor,
- mindestens eine Siliziumquelle, insbesondere eine Siliziumgasquelle, die einen Verdampfer enthält,
- eine Erfassungseinheit zum Erfassen des Verhältnisses von Silizium zu einem Trägergas, und
- eine Regeleinheit, die eingangsseitig mit der Erfassungseinheit und ausgangsseitig mit der Verdampfereinheit oder einer Durchflussbeeinflussungseinheit zur Beeinflussung des Flusses des Gasgemisches verknüpft ist, das vom Verdampfer kommt.

Die Stabilisierung der bspw. eine Siliziumgaskonzentration im Prozessgas durch eine Absolutmessung des Verhältnisse von bspw. Trichlorsilan auf der eine Seite und Trägergas auf der anderen Seite im Verdampfergas führt zu einem stabilen Gesamtprozess. Beispielsweise wird ein Ultraschalllaufzeitverfahren eingesetzt. Bei einer Ausgestaltung wird der Trägergasfluss durch den Verdampfer bzw. Bubbler geregelt.

Weitere Verbesserungen betreffen:
- zusätzliche Filter in allen Gasversorgungsleitungen der Anlage. Die Filter Verhindern Rückströmungen von Partikeln in das Gassystem bei einem eventuellen Überdruck in der Prozesskammer.
- ein Sicherheitsventil in der Trägergaszuleitung, insbesondere in einer Wasserstoffzuleitung, wodurch bei Warnmeldungen, insbesondere bei Gaswarnmeldungen, oder bei Problemen mit der Anlage die Trägergasversorgung der Anlage unterbrochen wird,
- Rückschlagventile in allen Gaszuleitungen der Anlage verhindern die Rückströmung von Gasen bei Druckschwankungen in den Versorgungsleitungen,
- eine Hilfsdotierung wird in auswählbare Reaktorleitungen oder Gruppen von Reaktorleitungen bspw. in die äußeren oder die innere Reaktorleitung eingeleitet. Damit wird eine gleichmäßigere Dotierstoffverteilung über die gesamte Halbleiterscheibe erreicht.
- Spülanschlüsse für ein Spülgas an allen Gasversorgungsleitungen. Der Ausbau von Teilen aus der Gasversorgungsanordnung, insbesondere von Durchflussbeeinflussungseinrichtungen ist auf sichere Art und Weise nach dem Spülen möglich. Als Spülgas ist insbesondere Stickstoff geeignet.
- Druckmesser in allen Versorgungsleitungen ermöglichen eine bessere Überwachung der Anlage.

Durch die Erfindung wird jeweils ein Gasversorgungssystem mit einer hervorragenden technischen Wirkung angegeben, insbesondere für die unter Nutzung des Gasversorgungssystems hergestellten Produkte und insbesondere für den Betrieb des Gasversorgungssystems. So erhöht sich die Qualität einer Epitaxieschicht erheblich, insbesondere bezüglich der Gleichmäßigkeit der Dotierstoffkonzentration in der Schicht. Dadurch verbessern sich die elektronischen Eigenschaften von in der Epitaxieschicht angeordneten Halbleiterbauelementen sowie die Ausbeute. Die elektronischen Eigenschaften liegen außerdem in einem kleineren Toleranzbereich.

Das wesentliche Prinzip beruht auf der Trennung der Prozessgase von den Reinigungsgasen bis unmittelbar vor die Prozesskammer. Weiterhin ermöglicht die Gasbox eine Druckstabilisierung aller Gase. Eine weitere wesentliche Wirkung besteht darin alle Durchflussbeeinflussungseinheiten zu überwachen und die Gasbox auf Dichtheit zu prüfen.

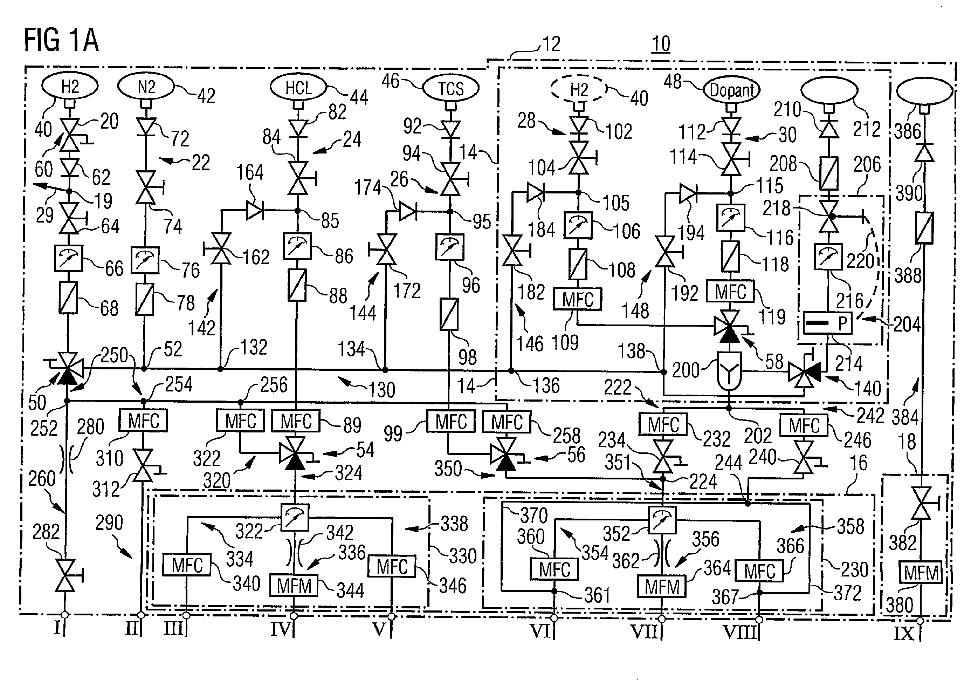

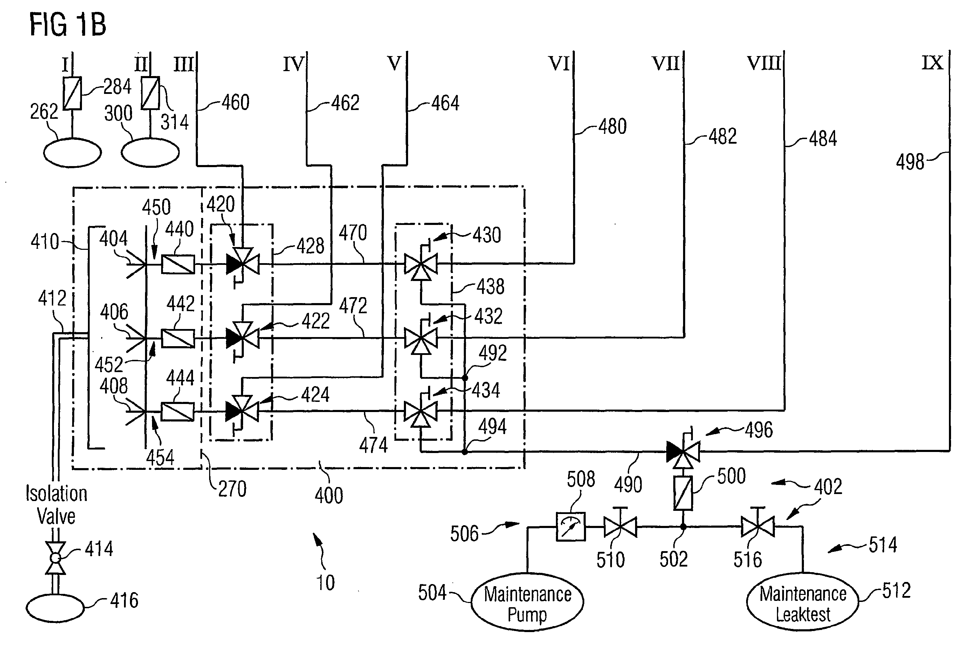

Im folgenden werden Ausführungsbeispiele der Erfindung an Hand der beiliegenden Zeichnungen erläutert. Darin zeigen: Figuren 1A und 1B eine Anlage zum Herstellen von dotierten Epitaxieschichten auf Halbleiterwafern.

Figur 1A zeigt den ersten Teil einer Epitaxieanlage 10, nämlich eine Gasbox 12. Die Gasbox 12 enthält eine Wasserstoff-Dotierstoff-Mischeinheit 14, eine Regelungseinheit 16 und eine Referenzeinheit 18. In der Gasbox 12 sind außerdem mehrere Gasversorgungsleitungen enthalten, nämlich:
- eine eine Verzweigung 19 enthaltende Wasserstoff-Versorgungsleitung 20,
- eine Stickstoff-Versorgungsleitung 22,
- eine Chlorwasserstoff-Versorgungsleitung 24,
- eine Trichlorsilan-Versorgungsleitung 26,
- eine von der Verzweigung 19 abzweigende Wasserstoff-Versorgungsleitung 28 in der Mischeinheit 14, siehe Abzweigung 29, und
- eine Phosphin-Versorgungsleitung 30 in der Mischeinheit 14.

Die Versorgungsleitungen 20, 22, 24, 26 und 30 werden in dieser Reihenfolge von einer Wasserstoffquelle 40 (Gasdruck bspw. 25+/-2 PSIG), einer Stickstoffquelle 42 (Gasdruck bspw. 30+/-2 PSIG), einer Chlorwasserstoffquelle 44 (Gasdruck bspw. 20+/-2 PSIG), einer Trichlorsilanquelle 46 (Gasdruck bspw. 20+/-2 PSIG) und einer Phosphinquelle 48 gespeist. Die Phospinquelle liefert bspw. 20 ppm Phospin verdünnt mit Argon.

Die Versorgungsleitungen 20, 22, 24, 26, führen in dieser Reihenfolge zu einem Nebenanschluss eines Umschaltventils 50, zu einer Verzweigung 52, zu einem Nebenanschluss eines Umschaltventils 54 und zu einem Nebenanschluss eines Mischventils 56. Die beiden Versorgungsleitungen 28 und 30 führen zu den Nebenanschlüssen eines Mischventils 58, das Bestandteil der Mischeinheit 14 ist.

Die Wasserstoff-Versorgungsleitung 20 enthält in der Reihenfolge von der Wasserstoffquelle 40 zum Umschaltventil 50:
- ein pneumatisch betätigtes Sicherheitsventil 60, das im Grundzustand offen ist,
- ein Rückschlagventil 62,
- ein manuell betätigbares Ventil 64,
- einen Druckmesser 66, und
- ein Filter 68.

Die Stickstoff-Versorgungsleitung 22 enthält in der Reihenfolge von der Stickstoffquelle 42 zur Verzweigung 52:
- ein Rückschlagventil 72,
- ein manuell betätigbares Ventil 74,
- einen Druckmesser 76, und
- ein Filter 78.

Die Chlorwasserstoff-Versorgungsleitung 24 enthält in der Reihenfolge von der Chlorwasserstoffquelle 44 zum Umschaltventil 54:
- ein Rückschlagventil 82,
- ein manuell betätigbares Ventil 84,
- eine Verzweigung 85,
- einen Druckmesser 86,
- ein Filter 88, und
- einen Massedurchsatzregler 89.

Die Trichlorsilan-Versorgungsleitung 26 enthält in der Reihenfolge von der Trichlorsilanquelle 46 zum Mischventil 56:
- ein Rückschlagventil 92,
- ein manuell betätigbares Ventil 94,
- eine Verzweigung 95,
- einen Druckmesser 96,
- ein Filter 98, und
- einen Massedurchsatzregler 99.

Die Versorgungsleitung 28 enthält in der Reihenfolge von der Verzweigung 19 zum Mischventil 58:
- ein Rückschlagventil 102,
- ein manuell betätigbares Ventil 104,
- eine Verzweigung 105,
- einen Druckmesser 106,
- ein Filter 108, und
- einen Massedurchsatzregler 109.

Die Phosphin-Versorgungsleitung 30 enthält in der Reihenfolge von der Phosphinquelle 48 zum Mischventil 58:
- ein Rückschlagventil 112,
- ein manuell betätigbares Ventil 114,
- eine Verzweigung 115,
- einen Druckmesser 116,
- ein Filter 118, und
- einen Massedurchsatzregler 119.

An der Verzweigung 52 verzweigt die Versorgungsleitung 22, zu dem anderen Nebenanschluss des Umschaltventils 50 und zu einer Stickstoff-Sammelleitung 130, die vier Verzweigungen 132 bis 138 enthält, von denen die Verzweigungen 136 und 138 Bestandteil der Mischeinheit 14 sind, und die zu dem einen Nebenanschluss eines Mischventils 140 führt, das Bestandteil der Mischeinheit 14 ist.

Von den Verzweigungen 132 bis 138 zweigt jeweils eine von vier Ventilleitungen 142 bis 148 ab, die in dieser Reihenfolge an der Verzweigung 85, 95, 105 bzw. 115 enden.

Die Ventilleitung 142 enthält in der Reihenfolge von der Verzeigung 132 zur Verzweigung 85:
- ein manuelles Ventil 162, und
- ein Rückschlagventil 164.

Die Ventilleitung 144 enthält in der Reihenfolge von der Verzeigung 134 zur Verzweigung 95:
- ein manuelles Ventil 172, und
- ein Rückschlagventil 174.

Die Ventilleitung 146 enthält in der Reihenfolge von der Verzeigung 136 zur Verzweigung 105:
- ein manuelles Ventil 182, und
- ein Rückschlagventil 184.

Die Ventilleitung 148 enthält in der Reihenfolge von der Verzeigung 136 zur Verzweigung 115:
- ein manuelles Ventil 192, und
- ein Rückschlagventil 194.

Die Mischeinheit 14 enthält außerdem eine Mischeinrichtung 200, bspw. eine Kammer, in der eine Metallspirale angeordnet ist. Ein Kammereinlass der Mischeinrichtung 200 ist mit dem Hauptanschluss des Mischventils 58 strömungstechnisch verbunden. Ein Kammerauslass der Mischeinrichtung 200 führt zu einer außerhalb der Mischeinheit 14 angeordneten Verzweigung 202. Außerdem gibt es in der Mischeinrichtung 200 ein Öffnung, die mit dem anderen Nebenanschluss des Mischventils 140 über einen Strömungskanal verbunden ist.

Der Hauptanschluss des Mischventils 140 führt zu einer in der Mischeinheit 14 enthaltenen Gasentlüftungsleitung 204, die mit zunehmenden Abstand von dem Mischventil 140 enthält:
- eine Drucküberwachungseinheit 206,
- einen Filter 208, und
- ein Rückschlagventil 210.

Die Gasentlüftungsleitung 204 führt zu einer Gasreinigungsanlage 212. Der Drucküberwachungseinheit 206 enthält eine Grenzwertüberwachungseinheit 206, einen Druckmesser 216 und ein Ventil 216. Der Grenzwertüberwachungseinheit wird bspw. ein oberer Grenzwert und ein unterer Grenzwert vorgegeben. Bei einer Grenzwertüberschreitung oder einer Grenzwertunterschreitung wird automatisch ein Signal erzeugt. Vorzugsweise automatisch wird abhängig von dem Signal das Ventil 218 derart nachgestellt, siehe gestrichelte Linie 220, dass sich der Druck in der Mischeinrichtung 200 wieder zwischen den beiden Grenzwerten einstellt.

Von der Verzweigung 202 führt eine Gasleitung 222 zu einer Zusammenführung 224,die einer in der Regelungseinheit 16 enthaltenen Prozesseinheit 230 vorgeschaltet ist. Die Gasleitung 222 enthält in der Reihenfolge von der Verzweigung 202 bis zu der Zusammenführung 204 einen Massedurchsatzregler 232 und eine pneumatisch betätigtes Ventil 234, das in seiner Grundstellung geöffnet ist.

Von der Verzweigung 202 führt ein Hilfdotierungs-Gasleitung 242 zu einer in der Prozesseinheit 230 angeordneten Verzweigung 244. Die Gasleitung 242 enthält in der Reihenfolge von der Verzweigung 202 bis zu der Verzweigung 244 einen Massedurchsatzregler 246 und ein pneumatisch betätigtes Ventil 248, das in seiner Grundstellung geöffnet ist.

Vom Hauptanschluss des Umschaltventils 50 führt eine Wasserstoff-Sammelleitung 250 zu dem anderen Nebenanschluss des Mischventils 56. Der Hauptanschluss des Mischventils 56 ist mit der Zusammenführung 224 verbunden. Die Sammelleitung 250 enthält in der Reihenfolge von dem Umschaltventil 50 zu dem Mischventil 56 drei Verzweigungen 252 bis 256 und einen Massedurchsatzregler 258.

Von der Verzweigung 252 führt eine Leitung 260 über ein Port I der Gasbox 12 zu einem Dichtungsauslass an einem rotierbaren Waferträger 262 in einer Prozesskammer 270, die in Figur 1B dargestellt ist. Die Leitung 260 enthält in der Reihenfolge von der Verzweigung 252 zu dem Waferträger 262 eine Drossel 280, ein manuelles Ventil 282, den Port I und einen in Figur 1B dargestellten Filter 284.

Von der Verzweigung 254 führt eine Leitung 290 über ein Port II der Gasbox 12 zu einem Schlitzventil 300 in der Prozesskammer 270, die in Figur 1B dargestellt ist. Die Leitung 290 enthält in der Reihenfolge von der Verzweigung 254 zu dem Schlitzventil 300 einen Massedurchsatzregler 310, ein pneumatisch betätigtes Ventil 312, den Port II und einen in Figur 1B dargestellten Filter 314.

Von der Verzweigung 256 führt eine Leitung 320 zu dem anderen Nebenanschluss des Umschaltventils 54. Die Leitung 320 enthält einen Massedurchsatzregler 322. Der Hauptanschluss des Umschaltventils 54 ist über eine Leitung 324 strömungstechnisch mit dem Eingang einer Hilfseinheit 330 verbunden, die Bestandteil der Prozesseinheit 230 ist.

Die Leitung 324 führt zu einer in der Hilfseinheit 330 angeordneten Verzweigung 322 mit Druckmesser. Von der Verzweigung 322, zweigen eine Hilfsleitung 334, eine mittlere Hilfsleitung 336 und eine Hilfsleitung 338 ab, die in dieser Reihenfolge zu Ports III, IV und V der Gasbox 14 führen. Die Hilfsleitung 334 enthält einen Massedurchsatzregler 340. Die mittlere Hilfsleitung 336 enthält in der Reihenfolge von der Verzweigung 322 zum Port IV eine Drossel 342, bspw. eine Vordruckregeleinheit, und eine Massedurchsatzerfassungseinheit 344. Die Hilfsleitung 338 enthält einen Massedurchsatzregler 346.

Vom Hauptanschluss des Mischventils 56 führt eine Leitung 350 zu der Verzweigung 224. Von der Verzweigung 224 führt eine Leitung 351 zu einem Eingang der Prozesseinheit 230.

Die Leitung 351 führt zu einer in der Prozesseinheit 230 angeordneten Verzweigung 352 mit Druckmesser. An der Verzweigung 352, sind eine Prozessleitung 354, eine mittlere Prozessleitung 356 und eine Prozessleitung 358 ab, die in dieser Reihenfolge zu Ports VI, VII und VIII der Gasbox 14 führen. Die Prozessleitung 354 enthält in der Reihenfolge von der Verzweigung 352 zu dem Port VI einen Massedurchsatzregler 360 und eine Zusammenführung 361. Die mittlere Prozessleitung 356 enthält in der Reihenfolge von der Verzweigung 352 zum Port VII eine Drossel 362, bspw. eine Vordruckreglereinheit, und eine Massedurchsatzerfassungseinheit 364. Die Prozessleitung 358 enthält in der Reihenfolge von der Verzweigung 352 einen Massedurchsatzregler 366 und eine Zusammenführung 367.

In der Prozesseinheit 230 führt von der Verzweigung 244 eine Hilfsdotierleitung 370 zu der Zusammenführung 361. Eine Hilfsdotierleitung 372 führt zu der Verzeigung 367.

Die Referenzeinheit 18 ist eingangsseitig mit einem Port IX der Gasbox 12 strömungstechnisch verbunden. Die Referenzeinheit 18 enthält in der Reihenfolge von ihrem Eingang zu ihrem Ausgang eine Referenz-Massedurchsatzerfassungseinheit 380 und ein manuelles Ventil 382. Vom Ventil 382 führt eine Gasentlüftungsleitung 384 zu einer Gasreinigungsanlage 386. Die Gasentlüftungsleitung 384 enthält in der Reihenfolge von der Referenzeinheit 18 bis zur Gasreinigungsanlage einen Filter 388 und ein Rückschlagventil 390.

Wie in Figur 1B dargestellt enthält die Epitaxieanlage eine an der Prozesskammer 270 angeordnete Ventileinheit 400 und eine Wartungseinheit 402. In der Prozesskammer 270, die in Figur 1B in Draufsicht dargestellt ist, befindet sich in einer Reihe angeordnet ein Gaseinlass 404, ein mittlerer Gaseinlass 406 und ein Gaseinlass 408. Den Gaseinlässen 404 bis 408 gegenüberliegend ist ein Gasauslasskanal 410 angeordnet, der die nicht verbrauchten Prozessgase und die Reaktionsgase aus der Prozesskammer 270 zu einer Gasauslassleitung 412 leitet, die ein Isolationsventil 414 enthält und zu einer Epitaxiegas-Waschanlage 416 führt. Der Halbleiterwafer, auf den die dotierte Epitaxieschicht aufgebracht wird, ist auf einem nicht dargestellten Auflagetisch des Waferträgers 262 zwischen den Gaseinlässen 404 bis 408 auf der einen Seite und dem Gasauslasskanal 410 auf der anderen Seite angeordnet.

Die Ventileinheit 400 enthält drei gleichzeitig betätigbare Umschaltventile 420, 422 und 424. Die gleichzeitige Betätigung ist durch eine gestrichelt Linie 428 angedeutet. Weiterhin enthält die Ventileinheit 400 drei gleichzeitig schaltbare Universalventile 430 bis 434, die jeweils drei gleichberechtigte Anschlüsse haben, zwischen denen wahlweise eine von drei Verbindungen geschaltet werden kann, nämlich:
- eine Verbindung zwischen dem ersten Anschluss und dem zweiten Anschluss,
- eine Verbindung zwischen dem zweiten Anschluss und dem dritten Anschluss, und
- eine Verbindung zwischen dem ersten Anschluss und dem dritten Anschluss.
Eine gestrichelte Linie 438 verdeutlicht die gleichzeitig Ansteuerung der Universalventile 430 bis 438.

Die Hauptanschlüsse der Umschaltventile 420, 422 und 424 sind in dieser Reihenfolge unter Zwischenschaltung jeweils eines Filters 440, 442 bzw. 444 mit dem Gaseinlass 404, mit dem mittleren Gaseinlass 406 bzw. mit dem Gaseinlass 408 über jeweils eine Reaktorgasleitung 450, 452 bzw. 454 verbunden, die möglichst kurz ist. Im Ausführungsbeispiel ist eine Reaktorgasleitung 450, 452 bzw. 453 nur jeweils 15 Zentimeter lang. Bei einem anderen Ausführungsbeispiel sind die Filter 440 bis 444 weggelassen und die Reaktorleitungen 450 bis 454 sind noch kürzer ausgebildet.

Der eine Nebenanschluss des Umschaltventils 420 ist über eine Leitung 460 mit dem Port III verbunden. Vom Port IV führt eine Leitung 462 zu dem einen Nebenanschluss der Umschalteinheit 422. Eine Leitung 464 führt vom Port V zu dem einen Nebenanschluss des Umschaltventils 424.

Zwischen dem anderen Nebenanschluss des Umschaltventils 420 und dem ersten Anschluss des Universalventils 430 liegt eine kurze Zwischenventilleitung 470, die bspw. nur zehn Zentimeter lang ist. Ein ebenso kurze Zwischenventilleitung 472 liegt zwischen dem anderen Nebenanschluss des Umschaltventils 422 und dem ersten.Anschluss des Universalventils 432. Auch zwischen dem anderen Nebenanschluss des Umschaltventils 424 ist eine kurze Zwischenventilleitung 474 angeordnet.

Der Port VI ist über eine Leitung 480 mit dem zweiten Anschluss des Universalventils 430 verbunden. Eine Leitung 482 verbindet den Port VII mit dem zweiten Anschluss des Universalventils 432. Der zweite Anschluss des Universalventils 434 ist über eine Leitung 484 mit dem Port VIII verbunden.

Eine Umleitungsleitung 490 führt von dem dritten Anschluss des Universalventils 430 über zwei Zusammenführungen 492 und 494 zu dem Hauptanschluss eines Umschaltventils 496. An die Zusammenführung 492 ist der dritte Anschluss des Universalventils 432 angeschlossen. Die Zusammenführung 494 ist mit dem dritten Anschluss des Universalventils 434 verbunden.

In einer Umleitungsbetriebsart und in einer MFC-Testbetriebsart (Mass Flow Controller) des Umschaltventils 496 ist der Hauptanschluss des Umschaltventils 496 mit einem Nebenanschluss des Umschaltventils verbunden, von dem eine Leitung 498 zum Port IX führt.

In einer Lecktestbetriebsart des Umschaltventils 496 ist der Hauptanschluss dagegen nur mit dem anderen Nebenanschluss verbunden, der über ein Filter 500 zu einer Verzweigung 502 führt.

Zu der Verzweigung 502 führt von einer Vakuumpumpe 504 eine Leitung 506, die eine Druckmesser 508 und ein manuell betätigbares Ventil 510 enthält. Zu der Verzweigung 502 führt außerdem von einer Gasquelle 512 zum Einspeisen eines Ortungsgases eine Leitung 514, die ein manuelles Ventil 516 enthält.

Bei einer anderen Ausgestaltung werden an Stelle der manuell betätigbaren Ventile pneumatisch betätigte Ventile eingesetzt.

Die Umschaltventile 50, 54, 420 bis 424 und 496 werden pneumatisch betätigt und haben jeweils einen durch ein schwarzes ausgefülltes Dreieck dargestellten Hauptanschluss. Die Umschaltventile sind im Grundzustand geschlossen, so dass kein Gaskanal zwischen einem Nebenanschluss und dem Hauptanschluss frei ist. In einer ersten Schaltstellung wird der eine Nebenanschluss mit dem Hauptanschluss verbunden, wobei der andere Nebenanschluss keine Verbindung zum Hauptanschluss hat. In einer zweiten Schaltstellung wird der andere Nebenanschluss mit dem Hauptanschluss verbunden, wobei der eine Nebenanschluss keine Verbindung zum Hauptanschluss hat.

Die Mischventile 56, 58 und 140 werden ebenfalls pneumatisch betätigt und haben jeweils eine durch ein schwarzes ausgefülltes Dreieck dargestellten Nebenanschluss. Die Mischventile sind im Grundzustand, d.h. ohne Druckluftbeaufschlagung, geschlossen, so dass kein Gasdurchlass zwischen einem Nebenanschluss und einem Hauptanschluss frei ist. Im betätigten Zustand wird eine Zusammenführung von den Nebenkanälen zum Hauptkanal freigegeben.

Bei einem anderen Ausführungsbeispiel werden auch an Stelle der Umschaltventile 420 bis 424 Universalventile eingesetzt. Dadurch lassen sich auch die Hilfsgasleitung in den Lecktest und die Überprüfung von Massedurchsatzreglern einbeziehen.

Die Epitaxieanlage 10 enthält außerdem noch zwei weitere Gasboxen für zwei weitere Prozesskammern, denen ebenfalls Ventileinheiten vorgeschaltet sind, die wie die Ventileinheit 400 aufgebaut sind.

Im folgenden wird die Arbeitsweise der Epitaxieanlage 10 beim Prozessieren eines Halbleiterwafers in der Prozesskammer 270 erläutert. Dabei werden die folgenden Verfahrensschritte ausgeführt:
- Einbringen des Halbleiterwafers in die Prozesskammer unter Stickstoffatmosphäre,
- Spülen der Prozesskammer mit Wasserstoff zum desorbieren von Verunreinigungen von der Waferoberfläche und Kammerwänden
- Aufheizen, und damit Reinigung der Waferoberfläche, auf etwa 1100 °C bis 1200 °C mittels Heizlampen am Prozesskammerboden und an der Prozesskammerdecke,
- gleichzeitig Stabilisierung von Prozessgasflüssen durch Vorbeileiten an der Prozesskammer,
- Umschalten der Umschaltventile 420 bis 424 und 430 bis 434, so dass die Prozessgase in die Prozesskammer 270 gelangen,
- ggf. zusätzliches Dotiergas an den äußeren Gaseinlässen 404 und 408 bzw. alternativ am inneren Gaseinlass 406,
- Aufwachsen der dotierten Epitaxieschicht unter gleichbleibenden Prozessbedingungen bei Drehung des Wafers mit bspw. 30 Umdrehungen pro Minute,
- Ausschalten der Prozessgaserzeugung,
- Spülen mit Wasserstoff,
- Abkühlen, durch Einschalten des Kühlsystems bspw. Ausschaltung der Heizung
- Entnehmen des mit einer Epitaxieschicht versehenen Wafers aus der Prozesskammer 270,
- Reinigung der Prozesskammer 270 mit Chlorwasserstoff bei hohen Temperaturen und unter Nutzung einer Endpunktkontrolle.

Bei einem anderen Ausführungsbeispiel wird das Verhältnis des Trichlorsilanträgergases zu dem Trichlorsilan zwischen dem Massedurchsatzregler 99 und dem Mischventil 56 erfasst, insbesondere mit einem Ultraschalllaufzeitverfahren. Werden Abweichungen von einem Sollwert festgestellt, so wird der Trägergasfluss durch einen in der Gasquelle 46 enthaltenen Verdampfer geregelt. Alternativ wird mit dem Messsignal der Mischgasfluss aus dem Gassättiger mit der dem Massedurchflussregeler 99 (MFC) geregelt.

## Patentansprüche

1. Gasversorgungsanordnung (10) für einen Prozessreaktor (270),
mit einer Gasquellen-Umschalteinheit (420), die einen Hauptanschluss und mindestens zwei Nebenanschlüsse enthält und in der wahlweise ein Gasdurchlasskanal zwischen dem Hauptanschluss und dem einen Nebenanschluss oder zwischen dem Hauptanschluss und dem anderen Nebenanschluss geöffnet ist, mit einer ersten Prozessgasleitung (480, 470), deren eines Ende an dem einen Nebenanschluss der ersten Umschalteinheit (420) angeordnet ist,
mit einer ersten Hilfsleitung (460), deren eines Ende an dem anderen Nebenanschluss der Gasquellen-Umschalteinheit (420) angeordnet ist und die Bestandteil eines Gasquellenzweiges mit mindestens einer Gasquelle ist, die Hilfsgase am anderen Ende der ersten Hilfsleitung (460) einspeist,
mit einem Prozessreaktor (270), der mindestens einen Gaseinlassanschluss (404) enthält,
mit einer ersten Reaktorleitung (450), deren eines Ende an dem Hauptanschluss der Gasquellen-Umschalteinheit (420) und deren anderes Ende an dem Gaseinlassanschluss (404) angeordnet ist,
mit einer Umleitungs-Umschalteinheit (430), die einen ersten Anschluss, einen zweiten Anschluss einen dritten Anschluss enthält, wobei wahlweise ein Gasdurchlasskanal zwischen dem ersten Anschluss und dem zweiten Anschluss oder zwischen dem zweiten Anschluss und dem dritten Anschluss geöffnet ist,
mit einer zweiten Prozessgasleitung (480), deren eines Ende an dem zweiten Anschluss der Umleitungs-Umschalteinheit (430) angeordnet ist, wobei die beiden Prozessgasleitungen einen gemeinsamen Leitungsabschnitt (480) haben,
mit einer zweiten Hilfsleitung (490), deren eines Ende an dem dritten Anschluss der Umleitungs-Umschalteinheit (430) angeordnet ist und die Bestandteil eines Gasumleitungszweiges ist, durch den Prozessgase am Prozessreaktor (270) vorbei zu dem anderen Ende der Hilfsleitung geleitet werden,
und mit einer zweiten Reaktorleitung (450, 470), deren eines Ende an dem ersten Anschluss der Umleitungs-Umschalteinheit (430) und deren anderes Ende an dem Gaseinlassanschluss (404) angeordnet ist, wobei die beiden Reaktorleitungen einen gemeinsamen Leitungsabschnitt (450) haben,
wobei die beiden Reaktorleitungen (450) jeweils kürzer als ein Meter oder kürzer als fünfzig Zentimeter oder kürzer als fünfundzwanzig Zentimeter sind,
wobei die Gasquellen-Umschalteinheit (420) in der an die Umleitungs-Umschalteinheit (430) angeschlossenen Reaktorleitung (450, 470) enthalten ist.

2. Gasversorgungsanordnung (10) nach Anspruch 1, **dadurch gekennzeichnet, dass** eine Gasquelle eine Wasserstoffquelle (40) und eine weitere Gasquelle eine Chlorwasserstoffquelle (44) ist.

3. Gasversorgungsanordnung (10) nach Anspruch 1, **dadurch gekennzeichnet, dass** die zweite Hilfsleitung (490) Bestandteil eines Gasumleitungszweiges ist, durch den Prozessgase am Prozessreaktor (270) vorbei zu einem Gasauslass (386) geleitet werden.

4. Gasversorgungsanordnung (10) nach Anspruch 2 und 3, **dadurch gekennzeichnet, dass** die Prozessgasleitung (480) Bestandteil eines Prozessgasquellenzweiges mit mindestens einer Prozessgasquelle ist, die Prozessgase am anderen Ende der Prozessgasleitung in die Prozessgasleitung einspeist.

5. Gasversorgungsanordnung (10) nach Anspruch 4, **dadurch gekennzeichnet, dass** die Prozessgasquelle eine Wasserstoffquelle (40) und/oder eine Siliziumquelle (46) und/oder eine Dotierstoffquelle (48) enthält.

6. Gasversorgungsanordnung (10) nach einem der vorhergehenden Ansprüche, **gekennzeichnet durch** eine erste Gasleitung (28), die Bestandteil eines ersten Gasquellenzweiges ist,
eine zweite Gasleitung (30), die Bestandteil eines zweiten Gasquellenzweiges ist,
eine Gaszusammenführeinheit (58), die einen Hauptanschluss und mindestens zwei Nebenanschlüsse enthält, wobei das eine Ende der ersten Gasleitung (28) an den einen Nebenanschluss und das eine Ende der zweiten Gasleitung (30) an dem anderen Nebenanschluss angeordnet ist,
einer zwischen dem Hauptanschluss und mindestens einer Durchflussbeeinflussungseinheit angeordneten Verbundeinheit, die einen Gaskanal bildet,
und **durch** eine von der Verbundeinheit abzweigende Druckbeeinflussungseinheit (206), die den sich in der Verbundeinheit einstellenden Druck beeinflusst,
wobei die Druckbeeinflussungseinheit (206) eine Druckregeleinheit mit Druckerfassungseinheit (214), automatisch betätigtem Absperrelement (218) sowie einer eingangsseitig an der Druckerfassungseinheit und ausgangsseitig an dem Absperrelement (218) angeordneten Regeleinheit (220) ist.

7. Gasversorgungsanordnung (10) nach Anspruch 6, **gekennzeichnet durch** eine in der Verbundeinheit enthaltene Gasmischeinheit (200),
und mit einem an der Gasmischeinheit (200) angeordneten Gasdurchlass an dem die Verzweigung zur Druckbeeinflussungseinheit (206) angeordnet ist.

8. Gasversorgungsanordnung (10) nach Anspruch 6 oder 7, **gekennzeichnet durch** eine Ballastgasleitung (130), deren eines Ende zwischen der Verzweigung zur Druckbeeinflussungseinheit (206) und der Druckbeeinflussungseinheit (206) angeordnet ist und die Bestandteil eines Ballastgasquellenzweiges mit einer Ballastgasquelle ist, die Ballastgas durch das andere Ende der Ballastgasleitung in die Ballastgasquelle einspeist,
insbesondere einer Stickstoffquelle.

9. Gasversorgungsanordnung (10) nach einem der vorhergehenden Ansprüche, **gekennzeichnet durch** einen Rahmen zum Befestigen der folgenden Einheiten:
des Prozessreaktors (270) und mindestens eines weiteren Prozessreaktors, wobei die Prozessreaktoren jeweils eine eigene Prozesskammer enthalten, die von der anderen Prozesskammer getrennt ist,
eine erste Gasmischeinrichtung (14) für ein Verdünnungsgas und ein Dotiergas,
und **durch** eine zwischen der ersten Gasmischeinrichtung und dem ersten Prozessreaktor (270) angeordneten Gasversorgungszweig,
wobei der Rahmen mindesten eine weitere Gasmischeinrichtung trägt, die den gleichen Aufbau wie die erste Gasmischeinrichtung hat und von der ein zweiter Gasversorgungszweig zu dem weiteren Prozessreaktor führt.

10. Gasversorgungsanordnung (10) nach Anspruch 9, **dadurch gekennzeichnet, dass** an die erste Gasmischeinrichtung (12) und an die zweite Gasmischeinrichtung mindestens eine Dotiergasquelle angeschlossen ist, die Dotiergas mit einer Dotierstoffkonzentration größer als 0,1 ppm oder größer als 1 ppm liefert,
und dass die Gasversorgungsanordnung (10) mindestes zwei weitere Mischeinrichtungen (224) für ein weiteres Verringern der Dotierstoffkonzentration enthält.

11. Gasversorgungsanordnung (10) nach Anspruch 9 oder 10, **dadurch gekennzeichnet, dass** die Gasmischeinrichtungen (12) jeweils Gasmischeinrichtungen nach einem der Ansprüche 6 bis 8 sind.

12. Gasversorgungsanordnung (10) nach einem der vorhergehenden Ansprüche, **gekennzeichnet durch** mehrere Gasversorgungsleitungen (20 bis 30), an denen jeweils mindestens eine Gasquelle (40 bis 48) angeschlossen ist,
mindestens einen Prozessreaktor (270),
und **durch** ein Gasleitungssystem zwischen den Gasversorgungsleitungen (20 bis 30) und dem Prozessreaktor (270),
wobei an das Gasleitungssystem mindestens einer Unterdruckpumpe (504) angeschlossen ist, die im Vergleich zum Umgebungsdruck einen Unterdruck erzeugt,
und wobei in jeder Gasversorgungsleitung (20 bis 30) ein Absperrelement (60, 74 ,84) angeordnet ist.

13. Gasversorgungsanordnung (10) nach Anspruch 12, **dadurch gekennzeichnet, dass** die Unterdruckpumpe (504) über eine Leitung (506) angeschlossen ist, die von einer Umleitungs-Leitung (490) abzweigt, die Prozessgase und/oder Reinigungsgase am Prozessreaktor (270) vorbeileitet.

14. Gasversorgungsanordnung (10) nach Anspruch 13, **gekennzeichnet durch** eine Gasquelle (512), die an Stelle der Unterdruckpumpe (504) zuschaltbar ist.

15. Gasversorgungsanordnung (10) nach einem der vorhergehenden Ansprüche, **gekennzeichnet durch** mehrere Gasversorgungsleitungen (20 bis 30), an denen jeweils mindestens eine Gasquelle (40 bis 48) angeschlossen ist, mindestens einen Prozessreaktor (270),
ein Gasleitungssystem zwischen den Gasversorgungsleitungen (20 bis 30) und dem Prozessreaktor (270),
eine Umleitungs-Leitung (450), die Prozessgase und/oder Reinigungsgase am Prozessreaktor (270) vorbeileitet,
und **durch** eine in der Umleitungs-Leitung angeordnete Durchflusserfassungseinheit (380).

16. Gasversorgungsanordnung (10) nach einem der vorhergehenden Ansprüche, **gekennzeichnet durch** einen Prozessreaktor (270), der eine Prozesskammer, mindestens zwei äußere Gaseinlässe (404, 408) und einen zwischen den äußeren Gaseinlässen (404, 408) angeordneten inneren Gaseinlass (406) enthält,
eine erste äußere Reaktorleitung (450, 334), die zwischen dem einen äußeren Gaseinlass (404) und einer Gasquelle angeordnet ist,
eine zweite äußeren Reaktorleitung (454, 338), die zwischen dem anderen äußeren Gaseinlass (408) und der Gasquelle oder einer weiteren Gasquelle angeordnet ist,
und **durch** eine Durchflussbeeinflussungseinheit (340) in einem Abschnitt der ersten äußeren Reaktorleitung (450, 334),
wobei der Abschnitt der ersten äußeren Reaktorleitung (450, 334) kein Abschnitt der zweiten äußeren Reaktorleitung (454, 338) ist und wobei der Abschnitt der ersten äußeren Reaktorleitung (450, 334) an den Prozessreaktor (270) angrenzt.

17. Gasversorgungsanordnung (10) nach Anspruch 16, **dadurch gekennzeichnet, dass** eine weitere Durchflussbeeinflussungseinheit (346) in einem Abschnitt der zweiten äußeren Reaktorleitung (454, 338) angeordnet ist,
wobei der Abschnitt der zweiten äußeren Reaktorleitung (454, 338) kein Abschnitt der ersten äußeren Reaktorleitung (450, 334) ist und wobei der Abschnitt an den Prozessreaktor (270) angrenzt.

18. Gasversorgungsanordnung (10) nach Anspruch 17, **dadurch gekennzeichnet, dass** an oder vor einer Verzweigung (352), von der die äußeren Reaktorleitungen und die innere Reaktorleitung abzweigen, eine Gesamtgasflusserfassungseinheit (322, 89) angeordnet ist,
dass die innere Reaktorleitung (452,336) keine Durchflussbeeinflussungseinheit enthält.

19. Gasversorgungsanordnung (10) nach Anspruch 16, **dadurch gekennzeichnet, dass** an oder vor einer Verzweigung (332), von der die äußeren Reaktorleitungen und die innere Reaktorleitung abzweigen, eine Gesamtgasflusserfassungseinheit (322, 89) angeordnet ist,
dass die zweite äußere Reaktorleitung keine Durchflussbeeinflussungseinheit enthält.

20. Gasversorgungsanordnung (10) nach einem der Ansprüche 16 bis 19, **dadurch gekennzeichnet, dass** die Gasquelle eine Hilfsgasquelle ist, die ein Gas für einen Reinigungsschritt des Prozessreaktors und/oder für einen Reinigungsschritt eines Halbleiterwafers liefert.

21. Gasversorgungsanordnung (10) nach einem der Ansprüche 16 bis 19, **dadurch gekennzeichnet, dass** die Gasquelle eine Prozessgasquelle ist, die ein Prozessgas liefert.

22. Gasversorgungsanordnung (10) nach Anspruch 20 und 21,
**dadurch gekennzeichnet, dass** die beiden inneren Reaktorleitungen einen gemeinsamen Abschnitt haben, der an dem Prozessreaktor (270) endet,
dass die beiden ersten äußeren Reaktorleitungen einen gemeinsamen Abschnitt haben, der an dem Prozessreaktor (270) grenzt,
und dass die beiden zweiten äußeren Reaktorleitungen einen gemeinsamen Abschnitt haben, der an dem Prozessreaktor (270) grenzt.

23. Gasversorgungsanordnung (10) nach einem der vorhergehenden Ansprüche, **gekennzeichnet durch** einen Prozessreaktor (270),
eine automatische Endpunkterfassungseinrichtung, die den Endpunkt einer Reinigung des Prozessreaktors (270) erfasst.

24. Gasversorgungsanordnung (10) nach Anspruch 23, **dadurch gekennzeichnet, dass** die Endpunkterfassungseinrichtung eine Analyseeinheit enthält, die die bei der Reinigung entstehenden Prozessgase analysiert, insbesondere ein Massespektrometer.

25. Gasversorgungsanordnung (10) nach einem der vorhergehenden Ansprüche, **gekennzeichnet durch** einen Prozessreaktor (270),
mindestens eine Siliziumquelle (46), die einen Verdampfer enthält,
eine Erfassungseinheit zum Erfassen des Verhältnisses von Silizium zu einem Trägergas,
und **durch** eine Regeleinheit, die eingangsseitig mit der Erfassungseinheit und ausgangsseitig mit der Verdampfereinheit oder einer Gasflussregeleinheit für ein vom Verdampfer kommendes Mischgas verknüpft ist.

26. Gasversorgungsanordnung (10) nach einem der vorhergehenden Ansprüche, **dadurch gekennzeichnet, dass** der Prozessreaktor (270) eine Vorrichtung zur Aufnahme eines einzigen Halbleiterwafers enthält,
und das die Gasversorgungsanordnung (10) eine Gasversorgungsanordnung (10) für das Aufwachsen einer Epitaxieschicht ist.

27. Gasversorgungsanordnung (10) nach Anspruch 7, **dadurch gekennzeichnet, dass** die Gasmischeinheit (200) eine Spirale oder ein mit Löchern versehenes Blech enthält.

28. Gasversorgungsanordnung (10) nach Anspruch 8, **dadurch gekennzeichnet, dass** die Ballastgasquelle eine Stickstoffquelle enthält.

29. Gasversorgungsanordnung (10) nach Anspruch 18, **dadurch gekennzeichnet, dass** die innere Reaktorleitung (452,336) eine Durchflusserfassungseinheit enthält.

30. Gasversorgungsanordnung (10) nach Anspruch 19, **dadurch gekennzeichnet, dass** die zweite äußere Reaktorleitung vorzugsweise eine Durchflusserfassungseinheit enthält.

31. Gasversorgungsanordnung (10) nach Anspruch 20, **dadurch gekennzeichnet, dass** die Gasquelle eine Hilfsgasquelle eine Chlorwasserstoffquelle und/oder eine Wasserstoffquelle ist.

32. Gasversorgungsanordnung (10) nach Anspruch 21, **dadurch gekennzeichnet, dass** die Prozessgasquelle eine Wasserstoffquelle und/oder eine Siliziumquelle und/oder eine Dotierstoffquelle ist.

## Claims

1. Gas supply assembly (10) for a process reactor (270),
comprising a gas source switch-over unit (420), which contains a primary connection and at least two secondary connections and in which either a gas passage channel between the primary connection and one secondary connection or between the primary connection and the other secondary connection is open,
comprising a first process gas line (480, 470), one end of which is arranged at one secondary connection of the first switch-over unit (420),
comprising a first auxiliary line (460), one end of which is arranged at the other secondary connection of the gas source switch-over unit (420) and which is part of a gas source branch comprising at least one gas source which feeds auxiliary gases in at the other end of the first auxiliary line (460),
comprising a process reactor (270) containing at least one gas inlet connection (404),
comprising a first reactor line (450), one end of which is arranged at the primary connection of the gas source switch-over unit (420) and the other end of which is arranged at the gas inlet connection (404),
comprising a bypass switch-over unit (430) containing a first connection, a second connection and third connection, either a gas passage channel between the first connection and the second connection or between the second connection and the third connection being open,
comprising a second process gas line (480), one end of which is arranged at the second connection of the bypass switch-over unit (430), the two process gas lines having a common line section (480),
comprising a second auxiliary line (490), one end of which is arranged at the third connection of the bypass switch-over unit (430) and which is part of a gas bypass branch through which process gases are conducted past the process reactor (270) to the other end of the auxiliary line,
and comprising a second reactor line (450, 470) one end of which is arranged at the first connection of the bypass switch-over unit (430) and the other end of which is arranged at the gas inlet connection (404), the two reactor lines having a common line section (450),
the two reactor lines (450) in each case being shorter than one metre or shorter than fifty centimetres or shorter than twenty-five centimetres,
the gas source switch-over unit (420) being contained in the reactor line (450, 470) connected to the bypass switch-over unit (430).

2. Gas supply assembly (10) according to Claim 1, **characterized in that** one gas source is a hydrogen source (40) and a further gas source is a hydrogen chloride source (44).

3. Gas supply assembly (10) according to Claim 1, **characterized in that** the second auxiliary line (490) is part of a gas bypass branch through which process gases are conducted past the process reactor (270) to a gas outlet (386).

4. Gas supply assembly (10) according to Claims 2 and 3, **characterized in that** the process gas line (480) is part of a process gas source branch comprising at least one process gas source which feeds process gases into the process gas line at the other end of the process gas line.

5. Gas supply assembly (10) according to Claim 4, **characterized in that** the process gas source contains a hydrogen source (40) and/or silicon source (46) and/or a dopant source (48).

6. Gas supply assembly (10) according to one of the preceding claims, **characterized by** a first gas line (28), which is part of a first gas source branch,
a second gas line (30), which is part of a second gas source branch,
a gas combining unit (58) containing a primary connection and at least two secondary connections, one end of the first gas line (28) being arranged at one secondary connection and one end of the second gas line (30) being arranged at the other secondary connection,
a composite unit arranged between the primary connection and at least one flow influencing unit and forming a gas channel,
and by a pressure influencing unit (206), which branches off from the composite unit and influences the pressure established in the composite unit,
the pressure influencing unit (206) being a pressure control unit with pressure detection unit (214),
automatically actuated shut-off element (218) and also a control unit (220) arranged at the pressure detection unit on the input side and at the shut-off element (218) on the output side.

7. Gas supply assembly (10) according to Claim 6, **characterized by** a gas mixing unit (200) contained in the composite unit,
and comprising a gas passage which is arranged at the gas mixing unit (200) and at which the branching junction to the pressure influencing unit (206) is arranged.

8. Gas supply assembly (10) according to Claim 6 or 7, **characterized by** a ballast gas line (130), one end of which is arranged between the branching junction to the pressure influencing unit (206) and the pressure influencing unit (206) and which is part of a ballast gas source branch comprising a ballast gas source which feeds ballast gas into the ballast gas source through the other end of the ballast gas line, in particular a nitrogen source.

9. Gas supply assembly (10) according to one of the preceding claims, **characterized by** a frame for fixing the following units:
the process reactor (270) and at least one further process reactor, the process reactors in each case containing their own process chamber separate from the other process chamber,
a first gas mixing device (14) for a dilution gas and a doping gas,
and by a gas supply branch arranged between the first gas mixing device and the first process reactor (270),
the frame carrying at least one further gas mixing device which has the same construction as the first gas mixing device and from which a second gas supply branch leads to the further process reactor.

10. Gas supply assembly (10) according to Claim 9, **characterized in that** at least one doping gas source which supplies doping gas having a dopant concentration of greater than 0.1 ppm or greater than 1 ppm is connected to the first gas mixing device (12) and to the second gas mixing device,
and **in that** the gas supply assembly (10) contains at least two further mixing devices (224) for a further reduction of the dopant concentration.

11. Gas supply assembly (10) according to Claim 9 or 10, **characterized in that** the gas mixing devices (12) are in each case gas mixing devices according to one of Claims 6 to 8.

12. Gas supply assembly (10) according to one of the preceding claims, **characterized by** a plurality of gas supply lines (20 to 30), to each of which at least one gas source (40 to 48) is connected,
at least one process reactor (270),
and by a gas line system between the gas supply lines (20 to 30) and the process reactor (270),
at least one vacuum pump (504) that generates a vacuum in comparison with the ambient pressure is connected to the gas line system,
and a shut-off element (60, 74, 84) being arranged in each gas supply line (20 to 30).

13. Gas supply assembly (10) according to Claim 12, **characterized in that** the vacuum pump (504) is connected via a line (506) which branches off from a bypass line (490) which conducts process gases and/or cleaning gases past the process reactor (270).

14. Gas supply assembly (10) according to Claim 13, **characterized by** a gas source (512) which can be connected in instead of the vacuum pump (504).

15. Gas supply assembly (10) according to one of the preceding claims, **characterized by** a plurality of gas supply lines (20 to 30), to each of which at least one gas source (40 to 48) is connected,
at least one process reactor (270),
a gas line system between the gas supply lines (20 to 30) and the process reactor (270),
a bypass line (450) which conducts process gases and/or cleaning gases past the process reactor (270),
and by a flow detection unit (380) arranged in the bypass line.

16. Gas supply assembly (10) according to one of the preceding claims, **characterized by** a process reactor (270) containing a process chamber, at least two outer gas inlets (404, 408) and an inner gas inlet (406) arranged between the outer gas inlets (404, 408),
a first outer reactor line (450, 334), which is arranged between the one outer gas inlet (404) and a gas source,
a second outer reactor line (454, 338), which is arranged between the other outer gas inlet (408) and the gas source or a further gas source,
and by a flow influencing unit (340) in a section of the first outer reactor line (450, 334),
the section of the first outer reactor line (450, 334) not being a section of the second outer reactor line (454, 338), and the section of the first outer reactor line (450, 334) adjoining the process reactor (270).

17. Gas supply assembly (10) according to Claim 16, **characterized in that** a further flow influencing unit (346) is arranged in a section of the second outer reactor line (454, 338),
the section of the second outer reactor line (454, 338) not being a section of the first outer reactor line (450, 334), and the section adjoining the process reactor (270).

18. Gas supply assembly (10) according to Claim 17, **characterized in that** a total gas flow detection unit (322, 89) is arranged at or before a branching junction (352) from which the outer reactor lines and the inner reactor line branch off,
**in that** the inner reactor line (452, 336) does not contain a flow influencing unit.

19. Gas supply assembly (10) according to claim 16, **characterized in that** a total gas flow detection unit (322, 89) is arranged at or before a branching junction (332) from which the outer reactor lines and the inner reactor line branch off,
**in that** the second outer reactor line does not contain a flow influencing unit.

20. Gas supply assembly (10) according to one of Claims 16 to 19, **characterized in that** the gas source is an auxiliary gas source which supplies a gas for a cleaning step of the process reactor and/or for a cleaning step of a semiconductor wafer.

21. Gas supply assembly (10) according to one of Claims 16 to 19, **characterized in that** the gas source is a process gas source which supplies a process gas.

22. Gas supply assembly (10) according to Claims 20 and 21, **characterized in that** the two inner reactor lines have a common section that ends at the process reactor (270),
**in that** the two first outer reactor lines have a common section that adjoins the process reactor (270),
and **in that** the two second outer reactor lines have a common section that adjoins the process reactor (270).

23. Gas supply assembly (10) according to one of the preceding claims, **characterized by** a process reactor (270),
an automatic end point detection device, which detects the end point of a cleaning of the process reactor (270).

24. Gas supply assembly (10) according to Claim 23, **characterized in that** the end point detection device contains an analysis unit, which analyses the process gases that arise during cleaning, in particular a mass spectrometer.

25. Gas supply assembly (10) according to one of the preceding claims, **characterized by** a process reactor (270),
at least one silicon source (46) containing an evaporator,
a detection unit for detecting the ratio of silicon to a carrier gas,
and by a control unit linked, on the input side, to the detection unit and, on the output side, to the evaporator unit or a gas flow control unit for a mixing gas coming from the evaporator.

26. Gas supply assembly (10) according to one of the preceding claims, **characterized in that** the process reactor (270) contains an apparatus for receiving a single semiconductor wafer,
and **in that** the gas supply assembly (10) is a gas supply assembly (10) for growing an epitaxial layer.

27. Gas supply assembly (10) according to Claim 7, **characterized in that** the gas mixing unit (200) contains a helix or a metal sheet provided with holes.

28. Gas supply assembly (10) according to Claim 8, **characterized in that** the ballast gas source contains a nitrogen source.

29. Gas supply assembly (10) according to Claim 18, **characterized in that** the inner reactor line (452, 336) contains a flow detection unit.

30. Gas supply assembly (10) according to Claim 19, **characterized in that** the second outer reactor line preferably contains a flow detection unit.

31. Gas supply assembly (10) according to Claim 20, **characterized in that** the gas source is an auxiliary gas source, a hydrogen chloride source and/or a hydrogen source.

32. Gas supply assembly (10) according to Claim 21, **characterized in that** the process gas source is a hydrogen source and/or a silicon source and/or a dopant source.

## Revendications

1. Dispositif (10) d'alimentation en gaz pour un réacteur (270) de processus,
comprenant un groupe (420) de commutation de source de gaz, qui comporte un raccord principal et au moins deux raccords secondaires et dans lequel, au choix, un canal de passage du gaz est ouvert entre le raccord principal et l'un des raccords secondaires ou entre le raccord principal et l'autre raccord secondaire,
comprenant un premier conduit (480, 470) pour du gaz de processus, dont l'une des extrémités est montée sur l'un des raccords secondaires du premier groupe (420) de commutation,
comprenant un premier conduit (460) auxiliaire dont l'une des extrémités est montée sur l'autre raccord secondaire du groupe (420) de commutation de source de gaz et qui fait partie d'une dérivation de source de gaz ayant au moins une source de gaz, qui injecte des gaz auxiliaires à l'autre extrémité du premier conduit (460) auxiliaire,
comprenant un réacteur (270) de processus qui comporte au moins un raccord (404) d'entrée du gaz,
comprenant un premier conduit (450) de réacteur dont une extrémité est montée sur le raccord principal du groupe (420) de commutation de source de gaz et dont l'autre extrémité est montée sur le raccord (404) d'entrée du gaz,
comprenant un groupe (430) de commutation de dérivation qui comporte un premier raccord, un deuxième raccord et un troisième raccord, un canal de passage du gaz étant ouvert, au choix, entre le premier raccord et le deuxième raccord ou entre le deuxième raccord et le troisième raccord,
comprenant un deuxième conduit (480) pour du gaz de processus, dont l'une des extrémités est montée sur le deuxième raccord du groupe (430) de commutation de dérivation, les deux conduits pour du gaz de processus ayant un tronçon (480) de conduit qui est commun,
comprenant un deuxième conduit (490) auxiliaire dont l'une des extrémités est montée sur le troisième raccord du groupe (430) de commutation de dérivation et qui fait partie d'une branche de dérivation du gaz dans laquelle des gaz de processus sont envoyés en contournant le réacteur (270) de processus à l'autre extrémité du conduit auxiliaire,
et comprenant un deuxième conduit (450, 470) de réacteur dont l'une des extrémités est montée sur le premier raccord du groupe (430) de commutation de dérivation et l'autre extrémité est montée sur le raccord (404) d'entrée du gaz, les deux conduits de réacteur ayant un tronçon (450) de conduit qui est commun,
les deux conduits (450) de réacteur étant respectivement plus courts qu'un mètre ou plus courts que cinquante centimètres ou plus courts que vingt-cinq centimètres,
le groupe (420) de commutation de source de gaz étant contenu dans le conduit (450, 470) de réacteur raccordé au groupe (430) de commutation de dérivation.

2. Dispositif (10) d'alimentation en gaz suivant la revendication 1, **caractérisé en ce qu'**une source de gaz est une source (40) d'hydrogène et une autre source de gaz est une source (44) de gaz chlorhydrique.

3. Dispositif (10) d'alimentation en gaz suivant la revendication 1, **caractérisé en ce que** le deuxième conduit (490) auxiliaire fait partie d'une branche de dérivation du gaz, par laquelle des gaz de processus sont envoyés en contournant le réacteur (270) de processus à une sortie (386) de gaz.

4. Dispositif (10) d'alimentation en gaz suivant la revendication 2 et 3, **caractérisé en ce que** le conduit (480) de gaz de processus fait partie d'une branche de source de gaz de processus ayant au moins une source de gaz de processus, qui injecte des gaz de processus dans le conduit pour du gaz de processus à l'autre extrémité du conduit pour du gaz de processus.

5. Dispositif (10) d'alimentation en gaz suivant la revendication 4, **caractérisé en ce que** la source de gaz de processus est une source (40) d'hydrogène et/ou une source (46) de silicium et/ou une source (48) de substance de dopage.

6. Dispositif (10) d'alimentation en gaz suivant l'une des revendications précédentes, **caractérisé par** un premier conduit (28) pour du gaz qui fait partie d'une première branche de source de gaz,
par un deuxième conduit (30) pour du gaz qui fait partie d'une deuxième branche de source de gaz,
par un groupe (58) de réunion de gaz qui comporte un raccord principal et au moins deux raccords secondaires, l'une des extrémités du premier conduit (28) pour du gaz étant montée sur l'un des raccords secondaires et l'autre extrémité du deuxième conduit (30) pour du gaz sur l'autre raccord secondaire,
par un groupe de liaison disposé entre le raccord principal et au moins un groupe influençant le débit et formant un canal pour du gaz,
et par un groupe (206) qui est en dérivation de l'unité de liaison et qui influence la pression s'établissant dans le groupe de liaison,
le groupe (206) influençant la pression étant un groupe à régulation de la pression ayant un groupe (214) de détection de la pression, un élément (218) d'obturation actionné automatiquement, ainsi qu'un groupe (220) de régulation disposé, du côté entrée, sur le groupe de détection de la pression et, du côté sortie, sur l'élément (218) d'obturation.

7. Dispositif (10) d'alimentation en gaz suivant la revendication 6, **caractérisé par** un groupe (200) de mélange de gaz contenu dans le groupe de liaison,
et comprenant un passage pour du gaz qui est disposé sur le groupe (200) de mélange du gaz et sur lequel est disposée la dérivation allant au groupe (206) influençant la pression.

8. Dispositif (10) d'alimentation en gaz suivant la revendication 6 ou 7, **caractérisé par** un conduit (130) de gaz de ballast dont une extrémité est disposée entre la dérivation allant au groupe (206) influençant la pression et l'unité (206) influençant la pression et qui fait partie d'une tranche de source de gaz de ballast ayant une source de gaz de ballast, le gaz de ballast étant injecté dans la source de gaz de ballast par l'autre extrémité du conduit pour du gaz de ballast,
notamment une source d'azote.

9. Dispositif (10) d'alimentation en gaz suivant l'une des revendications précédentes, **caractérisé par** un bâti pour fixer les groupes suivants :
du réacteur (270) de processus et d'au moins un autre réacteur de processus, les réacteurs de processus contenant respectivement une propre chambre de processus qui est séparée de l'autre chambre de processus,
un premier dispositif (14) de mélange de gaz pour un gaz de dilution et un gaz de départ,
et par une deuxième branche d'alimentation en gaz disposée entre le premier dispositif de mélange du gaz et le premier réacteur (270) de processus,
dans lequel le bâti porte au moins un autre dispositif de mélange de gaz qui a la même structure que le premier dispositif de mélange de gaz et qui mène d'une deuxième branche d'alimentation en gaz à l'autre réacteur de processus.

10. Dispositif (10) d'alimentation en gaz suivant la revendication 9, **caractérisé en ce qu'**il est raccordé au premier dispositif (12) de mélange de gaz et au deuxième dispositif de mélange de gaz au moins une source de gaz de départ qui fournit du gaz de départ à une concentration de la substance de dopage supérieure à 0,1 ppm ou supérieure à 1 ppm,
et **en ce que** le dispositif (10) d'alimentation en gaz comporte au moins deux autres dispositifs (224) de mélange pour diminuer supplémentairement la concentration de la substance de dopage.

11. Dispositif (10) d'alimentation en gaz suivant la revendication 9 ou 10, **caractérisé en ce que** les dispositifs (12) de mélange de gaz sont respectivement des dispositifs de mélange de gaz suivant l'une des revendications 6 à 8.

12. Dispositif (10) d'alimentation en gaz suivant l'une des revendications précédentes, **caractérisé par** plusieurs conduits (20 à 30) d'alimentation en gaz auxquels est raccordée respectivement au moins une source (40 à 48) de gaz,
au moins un réacteur (270) de processus,
et par un système de conduit de gaz entre les conduits (20 à 30) d'alimentation en gaz et le réacteur (270) de processus,
dans lequel il est raccordé au système de conduit de gaz au moins une pompe (504) produisant une dépression par rapport à la pression ambiante,
et dans lequel il est monté un élément (60, 74, 84) d'obturation dans chaque conduit (20 à 30) d'alimentation en gaz.

13. Dispositif (10) d'alimentation en gaz suivant la revendication 12, **caractérisé en ce que** la pompe (504) de dépression est raccordée par un conduit (506) qui dérive d'un conduit (490) de déviation faisant que des gaz de processus et/ou des gaz de nettoyage contournent le réacteur (270) de processus.

14. Dispositif (10) d'alimentation en gaz suivant la revendication 13, **caractérisé par** une source (512) de gaz qui peut être branchée à la place de la pompe (504) de dépression.

15. Dispositif (10) d'alimentation en gaz suivant l'une des revendications précédentes, **caractérisé par** plusieurs conduits (20 à 30) d'alimentation en gaz auxquels est raccordée respectivement au moins une source (40 à 48) de gaz,
par au moins un réacteur (270) de processus,
par un système de conduit de gaz entre les conduits (20 à 30) d'alimentation en gaz et le réacteur (270) de processus,
par un conduit (450) de déviation qui fait que des gaz de processus et/ou des gaz de nettoyage contournent le réacteur (270) de processus,
et par un groupe (380) de détection de débit monté dans le conduit de déviation.

16. Dispositif (10) d'alimentation en gaz suivant l'une des revendications précédentes, **caractérisé par** un réacteur (270) de processus qui comporte une chambre de processus, au moins deux entrées (404, 408) extérieures de gaz et une entrée (406) intérieure de gaz disposée entre les deux entrées (404, 408) extérieures de gaz,
par un premier conduit (450, 334) extérieur de réacteur qui est disposé entre une entrée (404) extérieure de gaz et une source de gaz,
par un deuxième conduit (454, 338) extérieur de réacteur qui est disposé entre l'autre entrée (408) extérieure de gaz et la source de gaz ou une autre source de gaz,
et par un groupe (340) influençant le débit dans un tronçon du premier conduit (450, 334) extérieur de réacteur,
le tronçon du premier conduit (450, 334) extérieur de réacteur n'étant pas un tronçon du deuxième conduit (450, 338) extérieur de réacteur et le tronçon du premier conduit (450, 334) extérieur de réacteur étant voisin du réacteur (270) de processus.

17. Dispositif (10) d'alimentation en gaz suivant la revendication 16, **caractérisé en ce qu'**un autre groupe (346) influençant le débit est monté dans un tronçon du deuxième conduit (454, 338) extérieur de réacteur, le tronçon du deuxième conduit (454, 338) extérieur de réacteur n'étant pas un tronçon du premier conduit (450, 334) extérieur de réacteur et le tronçon étant voisin du réacteur (270) de processus.

18. Dispositif (10) d'alimentation en gaz suivant la revendication 17, **caractérisé en ce que**, sur ou avant une bifurcation (352) de laquelle les conduits extérieurs du réacteur et le conduit intérieur du réacteur bifurquent, est disposé un groupe (322, 89) de détection du gaz global,
**en ce que** le conduit (452, 336) intérieur de réacteur ne comporte pas de groupe influençant le débit.

19. Dispositif (10) d'alimentation en gaz suivant la revendication 16, **caractérisé en ce que**, sur ou avant une bifurcation (352) de laquelle les conduits extérieurs du réacteur et le conduit intérieur du réacteur bifurquent, est disposé un groupe (322, 89) de détection du gaz global,
**en ce que** le deuxième conduit extérieur du réacteur ne comporte pas de groupe influençant le débit.

20. Dispositif (10) d'alimentation en gaz suivant l'une des revendications 16 à 19, **caractérisé en ce que** la source de gaz est une source de gaz auxiliaire qui fournit un gaz pour un stade de nettoyage du réacteur de processus et/ou pour un stade de nettoyage d'une tranche de semi-conducteur.

21. Dispositif (10) d'alimentation en gaz suivant l'une des revendications 16 à 19, **caractérisé en ce que** la source de gaz est une source de gaz de processus qui fournit un gaz de processus.

22. Dispositif (10) d'alimentation en gaz suivant la revendication 20 et 21, **caractérisé en ce que** les deux conduits intérieurs de réacteur ont un tronçon commun qui se termine sur le réacteur (270) de processus,
**en ce que** les deux premiers conduits extérieurs de réacteur ont un tronçon commun qui est voisin du réacteur (270) de processus,
et **en ce que** les deux deuxièmes conduits extérieurs de réacteur ont un tronçon commun qui est voisin du réacteur (270) de processus.

23. Dispositif (10) d'alimentation en gaz suivant l'une des revendications précédentes, **caractérisé par** un réacteur (270) de processus,
un dispositif automatique de détection de point final qui détecte le point final d'un nettoyage du réacteur (270) de processus.

24. Dispositif (10) d'alimentation en gaz suivant la revendication 23, **caractérisé en ce que** le dispositif de détection du point final comporte un groupe d'analyse qui analyse les gaz de processus se formant lors du nettoyage, notamment un spectromètre de masse.

25. Dispositif (10) d'alimentation en gaz suivant l'une des revendications précédentes, **caractérisé par** un réacteur (270) de processus,
au moins une source (46) de silicium qui comporte un évaporateur,
un groupe de détection du rapport du silicium à un gaz porteur,
et par une unité de régulation qui est combinée, du côté entrée, au groupe de détection et, du côté sortie, au groupe d'évaporateur ou à un groupe de régulation du débit de gaz pour un gaz mixte venant de l'évaporateur.

26. Dispositif (10) d'alimentation en gaz suivant l'une des revendications précédentes, **caractérisé en ce que** le réacteur (270) de processus comporte un dispositif de réception d'une tranche unique de semi-conducteur,
et **en ce que** le dispositif (10) d'alimentation en gaz est un dispositif (10) d'alimentation en gaz pour la croissance d'une couche épitaxiale.

27. Dispositif (10) d'alimentation en gaz suivant la revendication 7, **caractérisé en ce que** le groupe (200) de mélange de gaz comporte un serpentin ou une tôle munie de trous.

28. Dispositif (10) d'alimentation en gaz suivant la revendication 8, **caractérisé en ce que** la source de gaz de ballast comporte une source d'azote.

29. Dispositif (10) d'alimentation en gaz suivant la revendication 18, **caractérisé en ce que** le conduit (452, 336) intérieur de réacteur comporte un groupe de détection du débit.

30. Dispositif (10) d'alimentation en gaz suivant la revendication 19, **caractérisé en ce que** le deuxième conduit extérieur de réacteur comporte, de préférence, un groupe de détection du débit.

31. Dispositif (10) d'alimentation en gaz suivant la revendication 20, **caractérisé en ce que** la source de gaz est une source de gaz auxiliaire, une source de gaz chlorhydrique et/ou une source d'hydrogène.

32. Dispositif (10) d'alimentation en gaz suivant la revendication 21, **caractérisé en ce que** la source de gaz de processus est une source d'hydrogène et/ou une source de silicium et/ou une source de substance de dopage.
